# FASCICULE DE BREVET EUROPEEN

(11) **EP 2 122 432 B1**
(45) Date de publication et mention de la délivrance du brevet: **09.09.2015**
(21) Numéro de dépôt: 08709081.7
(22) Date de dépôt: 18.02.2008
(51) Int. Cl.: G05F 1/67

(54) **LIMITEUR DE TENSION ET PROTECTION D'UN MODULE PHOTOVOLTAIQUE**
SPANNUNGSBEGRENZER UND SCHUTZ FÜR EIN FOTOVOLTAISCHES MODUL
VOLTAGE LIMITER AND PROTECTION FOR A PHOTOVOLTAIC MODULE

(30) Priorité: 20.02.2007 FR 0753383
(43) Date de publication de la demande: 25.11.2009
(73) Titulaire: Commissariat à l'Énergie Atomique et aux Énergies Alternatives, 75015 Paris (FR)
(72) Inventeur: PERICHON, Pierre, F-38500 Voiron (FR); CHATROUX, Daniel, F-38470 Teche (FR)
(74) Mandataire: Ilgart, Jean-Christophe
(86) Numéro de dépôt international: PCT/EP2008/051947
(87) Numéro de publication internationale: WO 2008/101902

(56) Documents cités:
- WO-A-98/44398
- US-A- 6 111 767

## Description

### DOMAINE TECHNIQUE ET ART ANTERIEUR

L'invention concerne un dispositif électronique de type limiteur de tension. Elle s'applique avec profit à un ou des modules photovoltaïques, qu'elle permet de protéger.

Actuellement, on connaît principalement 3 types de modules photovoltaïques : monocristallin, poly-cristallin et amorphe. La technologie amorphe présente certains avantages, notamment en termes de souplesse et de faible quantité de matériaux employés.

La tension et le courant débités par les modules photovoltaïques dépendent de plusieurs paramètres (ensoleillement, température), et peuvent varier d'une façon importante.

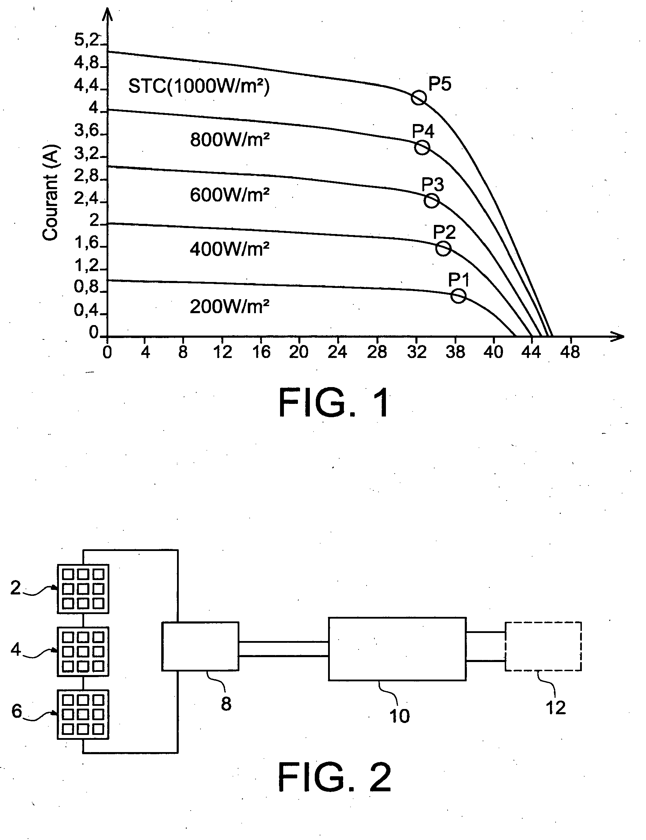

La figure 1 montre la caractéristique typique d'un module photovoltaïque en fonction de l'éclairement reçu (de 200 à 1000W/cm2). Le courant débité par le module varie fortement en fonction de cet éclairement (proportionnellement dans une première approximation). La tension, elle, reste pratiquement constante.

Les points de fonctionnement P1, P2,...Pn sur les courbes caractéristiques de la figure 1 sont les points où le module délivre le maximum de puissance pour un éclairement donné. On remarquera que la tension présente à ce moment là n'est pas la tension maximum pouvant apparaître aux bornes du module. Celle-ci est maximum pour un courant nul, lorsque le module est en circuit ouvert ou lorsque son énergie n'est pas absorbée.

Cette tension maximum dépend d'une façon importante de la température : elle vaut -156mV/°K pour un module monocristallin, -176mV/°K pour un module amorphe. Elle augmente donc à basse température. Cette variation est beaucoup plus importante pour les modules amorphes.

Afin d'optimiser la production d'énergie, les convertisseurs électroniques reliés aux modules photovoltaïques imposent la tension de fonctionnement des modules de façon à ce que ces derniers produisent le maximum de puissance (cette fonction est appelée MPPT = « maximum power point tracking »). Les convertisseurs peuvent cependant voir sur leurs entrées, dans certaines conditions, une tension beaucoup plus élevée qui correspond à la tension en circuit ouvert.

Les convertisseurs doivent donc avoir une plage de fonctionnement en tension sur leur entrée correspondant à la pleine variation possible de tension aux bornes des modules dans toutes les conditions. Le ratio entre la tension correspondant au maximum de puissance et la tension en circuit ouvert sur la plage de tension de fonctionnement peut atteindre : 1,4 pour des modules monocristallin ou poly-cristallin et jusqu'à 1,6 pour de l'amorphe.

En pratique, il est souhaitable que les plages de tension d'entrée des convertisseurs soient encore plus étendues pour laisser la possibilité de raccorder en série des nombres de modules différents selon l'implantation des panneaux photovoltaïques ou les tensions individuelles de ceux-ci.

Un problème posé par les dispositifs connus est l'association des convertisseurs et des rangées de modules.

Pour des raisons techniques (par exemple : modules placés sur un toit, les convertisseurs étant dans des locaux techniques), ou juridiques (limite de propriété), il arrive souvent que les convertisseurs de puissance soient installés assez loin des modules photovoltaïques produisant l'énergie. Afin de réduire les pertes par effet Joule dans les câbles, on associe les modules en série afin d'augmenter la tension et de diminuer le courant.

D'autre part, les tailles des cellules photovoltaïques sont standards et ont tendance à augmenter : 4 à 6 pouces aujourd'hui et même 8 pouces. Le courant fournit par une cellule dépend de sa surface, de l'éclairement bien sûr. La tension quant à elle, dépend du matériau. La tension et la puissance fournies par un module, qui est un assemblage de cellules en série, sont donc intimement reliées. De même, la puissance et la tension d'une entrée d'un convertisseur sont liées : plus la puissance est importante et plus la tension acceptable en entrée du convertisseur doit être élevée.

Le convertisseur, lui, est construit pour fournir une puissance maximale et est capable de fonctionner sur une plage donnée de tension d'entrée. Cette plage de tension a un impact important sur la conception du convertisseur et donc au final sur le coût.

Du fait des variations importantes de tension en température et/ou entre fonctionnement à vide et au point de puissance maximale déjà exposées ci-dessus, un seul assemblage de modules en série peut être relié à l'entrée d'un convertisseur et ce sans réelle possibilité d'évolution.

Toutes ces contraintes limitent ainsi considérablement la souplesse dans la réalisation des installations photovoltaïques en imposant la taille des modules, leurs nombres et les caractéristiques des convertisseurs. Les architectes ne disposent donc que de peu de latitude dans l'intégration et la taille des champs de modules photovoltaïques.

Enfin, une installation étant faite, il-est très difficile de la faire évoluer en ajoutant progressivement des modules (lors d'une évolution d'un budget par exemple). Il faut que l'installation soit complète dès le départ et les évolutions ne peuvent pas être graduelles.

Il se pose donc un problème, qui est de pouvoir associer et adapter des modules plus aisément.

Par ailleurs les systèmes photovoltaïques présentent des caractéristiques très différentes de celles qui sont habituelles sur les réseaux électriques.

En effet, les modules fournissent un courant continu dès qu'ils sont éclairés. Les installations photovoltaïques étant de plus en plus puissantes, les tensions présentent peuvent être de plusieurs centaines de volts en continu (typiquement entre 200V et 400V). Les courants également deviennent importants, typiquement de 10A à 20A par circuit.

Ces tensions et courants élevés en sorties de champ photovoltaïque sont dangereux, et sans réelle possibilité pour l'utilisateur d'interrompre le générateur.

La connexion et la déconnection des modules et convertisseurs doit donc très souvent se faire en fonctionnement, avec un risque important, qui est celui de générer un arc électrique destructeur pour les connections électriques et dangereux pour l'utilisateur. Cet arc est d'autant plus dangereux qu'il est créé par un courant continu, donc sans passage naturel par zéro. Il peut, dans certaines conditions, s'amorcer et être entretenu sans s'arrêter comme le ferait un courant alternatif.

Les protections habituelles (disjoncteurs et fusibles), ne détectent pas ces arcs électriques et ne sont donc pas efficaces. D'autre part, elles n'assurent pas correctement la protection contre les courts-circuits et surcharges, car les courants de court-circuit fournis par les champs photovoltaïques sont très proches des courants nominaux (1,2 fois environ). Les disjoncteurs et fusibles sont en général prévus pour laisser passer 1,15 fois le courant nominal sans déclencher ; au-delà, le temps d'ouverture est d'autant plus long que le courant est proche du courant nominal. Enfin, les interrupteurs, disjoncteurs et fusibles interrompent avec beaucoup de difficulté les courants continus.

Bien que les raccordements des modules photovoltaiques, entre eux et avec les convertisseurs, soient réalisés à l'aide de connecteurs spéciaux étanches présentant une bonne protection de l'utilisateur contre les contacts directs, il se pose donc un problème de protection de l'utilisateur lors des connections et déconnections des modules.

### EXPOSE DE L'INVENTION

Selon l'invention, on insère dans le circuit électrique, entre le champ photovoltaïque et le convertisseur, un limiteur électronique.

L'invention concerne d'abord un dispositif limiteur de tension d'un ensemble de modules photovoltaiques comportant :
- des moyens formant interrupteur électronique d'un courant dudit ensemble,
- des moyens de comparaison pour comparer une tension en sortie de limiteur à une valeur de tension de référence,
- des moyens de commande des moyens formant interrupteur électronique, en fonction du résultat de la comparaison effectuée par les moyens de comparaison.

Un tel dispositif selon l'invention permet de limiter la tension à vide en sortie des modules pour réduire les contraintes sur les convertisseurs et sur les câblages. Il facilite ainsi la réalisation d'une installation photovoltaïque en permettant une adaptation plus simple et plus versatile des champs de modules aux convertisseurs.

Un tel dispositif peut comporter en outre des moyens pour filtrer la tension mesurée en sortie de limiteur.

Un dispositif selon l'invention peut comporter en outre des moyens pour lisser une tension en sortie du dispositif limiteur.

Des moyens peuvent être prévus pour détecter une augmentation rapide de la tension en sortie du dispositif limiteur.

Le dispositif assure alors la protection de l'utilisateur en éliminant un éventuel arc électrique apparaissant du fait d'une déconnection se produisant lors du fonctionnement de la liaison entre les modules photovoltaïques et les convertisseurs.

Selon un mode de réalisation, les moyens pour détecter une augmentation rapide de la tension comportent des moyens pour calculer la dérivée temporelle de la tension en sortie du dispositif limiteur.

Selon un autre mode de réalisation la tension de référence du comparateur est fixée à une valeur supérieure à la tension correspondant au maximum de puissance du module photovoltaïque, par exemple à une valeur supérieure à la tension correspondant au maximum de puissance du module photovoltaïque, augmentée d'une tension V' strictement positive et inférieure à la tension générée par un arc électrique.

Des moyens d'adaptation de la tension de référence peuvent être prévus.

Par ailleurs, un dispositif selon l'invention peut comporter en outre des moyens de détection de court-circuit. Il protège alors des courts-circuits en sortie de module photovoltaïque : les moyens de détection de court-circuit commandent l'ouverture des moyens formant interrupteurs.

Par exemple, ces moyens de détection de court-circuit comportent un capteur de courant disposé en aval de l'interrupteur et des deuxièmes moyens de comparaison pour comparer une mesure issue de ce capteur a une valeur de référence. Des moyens de commande des moyens formant interrupteur électronique permettent d'ouvrir ou fermer les moyens formant interrupteur en fonction du résultat de la comparaison effectuée par les deuxièmes moyens de comparaison.

Des premiers et des deuxièmes moyens formant interrupteur peuvent être disposés respectivement en entrée et en sortie du dispositif.

Des moyens d'absorption d'énergie peuvent être disposés entre les deux bornes des moyens formant interrupteur, afin d'écrêter des surtensions générées lors de l'ouverture de ces moyens formant interrupteur.

L'invention concerne également un procédé de limitation de tension d'un module photovoltaïque, comportant la mise en oeuvre d'un dispositif selon l'invention, tel qu'exposé ci-dessus.

L'invention concerne également un dispositif de production d'énergie, comportant:
- au moins un module photovoltaïque,
- un dispositif selon l'invention, tel qu'expliqué ci-dessus,
- des moyens formant convertisseur électronique, pour imposer une tension de fonctionnement au module photovoltaïque.

Un dispositif selon l'invention peut être placé en sortie des modules photovoltaïques et en amont des convertisseurs de puissance et assurer plusieurs fonctions.

Certaines des fonctions d'un dispositif selon l'invention, par exemple les fonctions de comparaison, peuvent être réalisées de manière analogique, ou de manière numérique à l'aide par exemple d'un microcontrôleur.

### BRÈVE DESCRIPTION DES DESSINS

- la figure 1 représente des caractéristiques courants/tension d'un module photovoltaïque amorphe, en fonction de l'éclairement, à 25°C,
- la figure 2 représente une structure générale d'une installation photovoltaïque, comportant un limiteur de tension selon l'invention,
- les figures 3A et 3B représentent la structure de deux dispositifs limiteurs de tension selon l'invention,
- les figures 4, 6 et 9 sont diverses représentations détaillées d'un dispositif selon l'invention,
- la figure 8 illustre la structure d'un arc électrique établi,

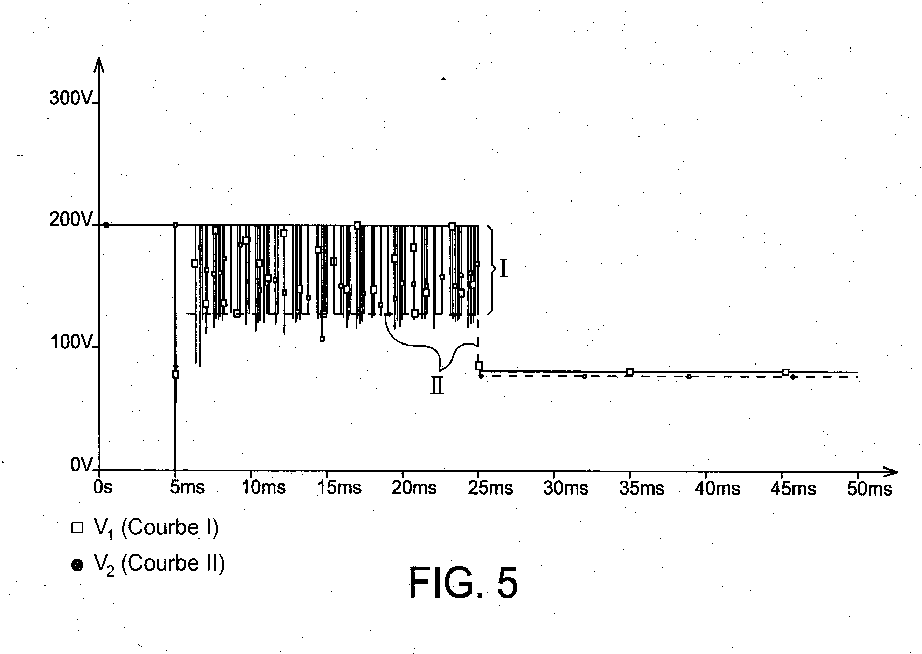

- les figures 5, 7A-7C, 10A, 10B, 11 représentent diverses grandeurs électriques mesurées dans des modes de réalisation de dispositifs selon l'invention.

### EXPOSE DETAILLE DE MODES DE REALISATION DE L'INVENTION

La figure 2 représente un premier mode de réalisation de l'invention : un limiteur électronique est inséré dans le circuit électrique, entre un champ photovoltaïque et un convertisseur.

Ainsi, sur cette figure, sont représentés 3 champs photovoltaïques 2, 4, 6, un limiteur de tension 8 selon l'invention, et un convertisseur 10, relié au réseau électrique 12. L'invention n'est pas limitée à trois champs photovoltaïques, mais s'applique à un nombre quelconque de ces champs. Dans la suite du texte, on désignera l'ensemble des champs voltaïques par la seule référence numérique 2.

Le dispositif 8 limiteur de tension selon l'invention est placé entre les modules photovoltaïques 2 et le convertisseur de puissance 10. Il est placé, de préférence, au plus près des modules photovoltaïques, afin d'assurer la protection la plus efficace contre les arcs électriques et les courts-circuits.

La place idéale est une installation directement en sortie de module photovoltaïque.

Le dispositif limiteur 8 assure une limitation de la tension à vide générée par le champ photovoltaïque et vue par les câbles de liaison et l'entrée du convertisseur 10.

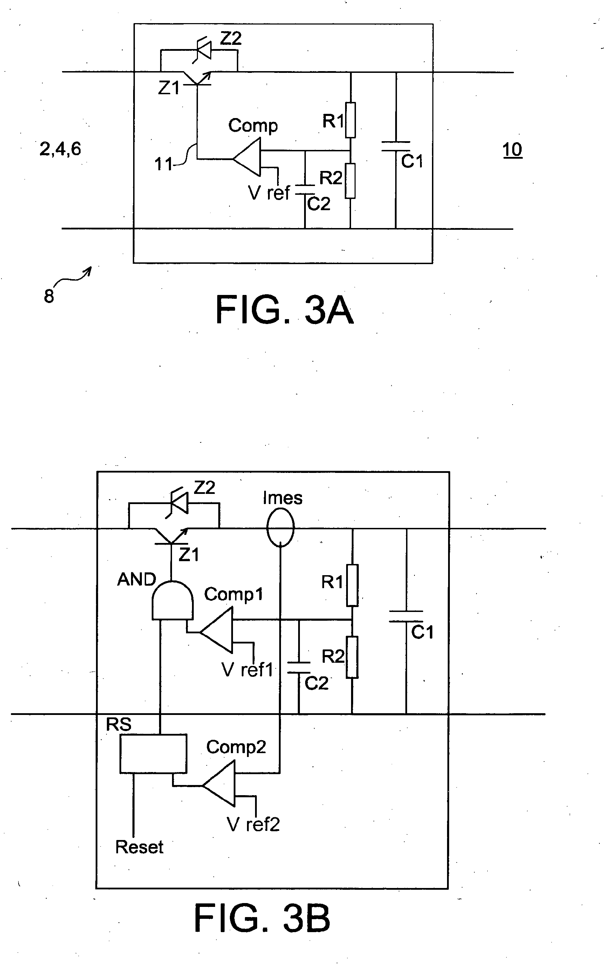

La figure 3A montre un schéma de principe d'un limiteur de tension 8 selon l'invention.

Un tel dispositif comporte des moyens formant interrupteur électronique Z1, permettant d'interrompre le courant continu (par exemple un Transistor bipolaire à grille isolée, ou IGBT, ou encore Mosfet) débité par le champ photovoltaïque.

Du côté du convertisseur 10, un condensateur C1 lisse la tension vue par l'entrée de ce convertisseur. Un comparateur Comp1 pilote, via les moyens de connexion 11, l'interrupteur Z1, en comparant la tension en sortie du limiteur de tension, via le pont diviseur R1 et R2, à une référence de tension VRef. Le dispositif peut en outre comporter un composant Z2, par exemple une diode Zener, formant moyen d'absorption d'énergie, qui écrête les surtensions générées par les inductances de câblage en amont et en aval du dispositif à l'ouverture de l'interrupteur Z1. Cette fonction d'écrèteur, en parallèle- sur l'interrupteur Z1, peut être réalisée par des composants extérieurs ou par le choix de composants écrêtant intrinsèquement, c'est-à-dire supportant le mode avalanche. C'est le cas pour de nombreux transistors MOSFETs par exemple.

Un condensateur C2 filtre la tension mesurée par R1/R2 afin de limiter la fréquence de commutation de l'interrupteur Z1. Cette fonction peut également être remplie par un hystérésis (réalisé par une résistance en contre réaction).placée aux bornes du comparateur Comp1.

La figure 3B montre un schéma de principe d'un autre limiteur de tension 8 selon l'invention. Il comporte les mêmes moyens que le schéma de la figure 3A. Ces mêmes moyens sont désignés par les mêmes références numériques et les explications correspondantes ne seront pas reprises.

Cet autre limiteur comporte en outre un capteur de courant en aval de l'interrupteur Z1. Sur la figure 3B, ce capteur est désigné par la référence Imes. Le courant de court-circuit d'un module photovoltaïque est très proche de son courant nominal (il y a seulement environ 15 à 20 % de différence). La détection du court-circuit se fait donc en comparant, grâce à un comparateur Comp2, le courant du capteur Imes à un seuil Vref2, égal au courant nominal fourni normalement par le module photovoltaïque, augmenté d'une fraction, par exemple 10 %, de ce courant nominal. Lorsque le seuil est dépassé, on commande l'ouverture de l'interrupteur Z1 à travers une bascule RS (qui mémorise la présence du court - circuit) et à travers une porte AND qui pilote l'interrupteur Z1. Ce dernier, un interrupteur électronique, interrompt le courant continu fourni par les modules photovoltaïques. Dans ce schéma, Z1 est activé lorsque les deux entrées de la porte AND sont à « 1 ». L'autre entrée de cette porte étant la sortie du comparateur Comp1, une tension anormale (trop élevée) ou un courant anormal (trop élevé) entraîne donc une ouverture de Z1.

Les dispositifs ci-dessus sont des réalisations analogiques. Les mêmes fonctionnalités peuvent être réali-sées par des moyens numériques. Par exemple le ou les comparateurs Comp1 et/ou Comp2 sont remplacés dans les schémas ci-dessus par un mcirocontrôleur, dans lequel on introduit les valeurs de tension mesurées puis numérisées. Dans la suite on fera surtout référence au mode de réalisation analogique des figures 3A et 3B, mais tout peut être transposé au mode de réalisation numérique.

Un dispositif selon l'invention présente plusieurs modes dans son fonctionnement.

Selon un premier mode, le convertisseur 10 est arrêté, et le champ photovoltaïque 2 est en fonctionnement.

L'invention permet alors de limiter la tension, générée par le champ photovoltaïque 2 et vue par le convertisseur 10, à une valeur un peu supérieure à la tension correspondant au point de puissance maximum (la notion de puissance maximum et de points de puissance maximum P1, P2,...Pn a déjà été expliquée ci-dessus, en liaison avec le figure 1) . Dans ce mode, le convertisseur 10 n'absorbe pas de courant.

Lorsque l'interrupteur Z1 est initialement fermé, le condensateur C1 se charge à travers Z1, les cellules photovoltaïques 2 se comportant comme des générateurs de courant.

Lorsque la tension aux bornes de C1, mesurée par le pont diviseur R1/R2, dépasse la valeur de VRef1, le comparateur Comp1 bascule, ouvrant l'interrupteur Z1.

La tension aux bornes de C1 décroît alors lentement, du fait des courants de fuite à travers le convertisseur 10 et à travers les autres éléments. Le comparateur Comp1 ayant, comme déjà expliqué ci-dessus, une légère hystérésis (ou un filtre tel que C2), il rebascule lorsque la tension aux bornes de C1 atteint le seuil bas, fermant ainsi l'interrupteur Z1 dans le cas de la figure 3A. Dans le cas de la figure 3B une deuxième condition, celle d'un courant normal (absence de court - circuit) s'ajoute à la première pour fermer Z1.

Le cycle recommence ainsi régulièrement à une fréquence dépendant de la valeur des composants, des courants de fuite, de l'hystérésis du comparateur etc... La tension aux bornes de C1 est ainsi régulée à une valeur fixée par la référence du comparateur. Cette valeur est fixée pour être un peu au-dessus de la tension correspondant au maximum de puissance du champ photovoltaïque 2, et de préférence très inférieure à la tension générée à vide par ce champ.

Par exemple, pour un champ photovoltaïque en cellules amorphes, la tension à vide étant de 400V, la tension au point de puissance maximum est de 250V (environ : 400 V/1,6). Le dispositif limite alors la tension à 300 V. Le convertisseur 10 de puissance voit donc une tension réduite à ses bornes de 300 V au lieu de 400 V.

Selon un deuxième mode de fonctionnement, le convertisseur 10 est en fonctionnement, ainsi que le champ photovoltaïque 2, 4, 6.

Lorsque le convertisseur s'active, il consomme un courant important. La tension aux bornes de C1 décroît très rapidement et passe sous le seuil de la référence du comparateur Comp1, et ce dernier ferme l'interrupteur Z1. Le convertisseur 10 impose une tension correspondant à la fourniture du maximum de puissance par le champ photovoltaïque. La tension mesurée par R1/R2 ne repasse donc pas au-dessus de la valeur de référence Vref1 car cette dernière a été réglée pour une tension aux bornes de C1 légèrement supérieure à la tension de puissance optimum du champ. L'interrupteur Z1 reste donc fermé en permanence, alimentant ainsi le convertisseur 10.

Dans un troisième mode de fonctionnement, il y a ouverture du circuit entre le dispositif limiteur 8 et le convertisseur 10.

Cette ouverture peut résulter de l'ouverture, accidentelle ou non, d'un connecteur ou d'une liaison électrique entre les moyens 8 et le convertisseur 10 (en entrée de convertisseur 10 par exemple). Il y a alors apparition instantanée d'un arc électrique entre une anode A et une cathode C.

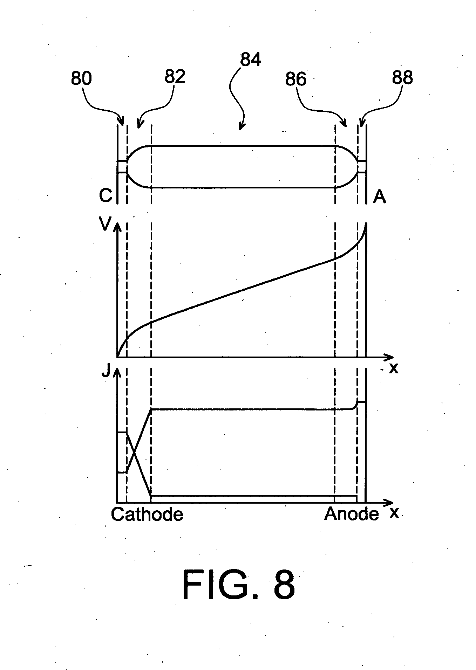

La figure 8 montre la structure simplifiée d'un arc électrique.

Schématiquement, ce dernier est constitué de plusieurs zones entre une anode A et une cathode C : 2 zones 80, 82 de charges d'espaces, proches des électrodes, dont chacune est de faible épaisseur (quelques µm), relativement froides (température < 1000°K), et une zone intermédiaire 84, qui est le coeur de l'arc et qui est constituée d'un plasma très chaud (température > à quelques milliers de °K). Les zones 80, 82 de transition électrode/air génèrent une chute de tension pratiquement indépendante du courant d'environ 10 V à 20 V. La zone intermédiaire 84 se comporte comme une résistance générant une chute de tension proportionnelle au courant.

Lorsque le courant est interrompu, la zone 84 reste chaude très longtemps (refroidissement par convection et rayonnement dans le milieu ambiant c'est-à-dire l'air, un isolant thermique) et reste donc fortement conductrice. Par contre les charges dans les zones 80 et 88 se recombinent très rapidement lorsque le courant est interrompu, et redeviennent très rapidement isolantes (en quelques µs après arrêt du courant).

Un arc électrique génère donc instantanément (en quelques µs), à son apparition, une chute de tension d'au moins 10 V à 20 V. Des capacités placées en entrée du convertisseur, sont de forte valeur devant C1. La tension à leurs bornes ne varie donc beaucoup plus lentement que la tension aux bornes de C1.

Afin de protéger l'utilisateur de l'arc électrique, on détecte cette augmentation rapide de la tension aux bornes de C1 (c'est par exemple une variation de 20 V environ en quelques ms). Il faut noter que la variation normale de tension due à la recherche du point de fonctionnement optimum du module photovoltaïque par le convertisseur est beaucoup plus lente (entre autre du fait des fortes capacités présentes en entrée du convertisseur). Cette variation rapide de tension est donc bien liée à l'apparition de l'arc électrique.

Le montage détecte cette variation de tension en réglant la référence Vref1 du comparateur Comp1 à une valeur égale à la tension correspondant au maximum de puissance du module photovoltaïque + une tension V', 0V<V'<la tension générée par l'arc électrique (qui est par exemple de l'ordre de 10 V).

Il est également possible de détecter la variation brutale de cette tension en faisant calculer sa dérivée, par exemple par un micro contrôleur tel que celui déjà évoqué ci-dessus en liaison avec les figures 3A et 3B (et qui remplace alors le comparateur Comp1 et/ou Comp2), et en comparant cette valeur à un seuil pré-défini. Cette tension est celle présente aux bornes de C1 lorsque le système est dans le deuxième mode de fonctionnement décrit précédemment. Le système peut donc fonctionner en mesurant cette tension et en adaptant automatiquement la référence de tension (apprentissage). En effet, les variations normales de cette tension sont lentes : quelques volts par seconde (recherche du point de fonctionnement optimum par la fonction MPPT du convertisseur (fonction déjà évoquée ci-dessus :« maximum power point tracking »), variation de tension du champ photovoltaïque due aux changements de température). Un filtrage glissant de cette tension sur une certaine durée (de, par exemple, 10 minutes) permet de déterminer la référence de tension (cette dernière évoluant très lentement au fil du temps). Une variation brutale par rapport à cette moyenne est anormale et correspond à l'apparition d'un arc électrique. Ces fonctions peuvent être réalisées de manière numérique avec un microcontrôleur, tel que celui déjà évoqué ci-dessus. Elles peuvent aussi être réalisées de manière analogique.

Une fois que la variation de tension est détectée, Z1 est ouvert pour interrompre le courant et éliminer ainsi l'arc électrique naissant. Cette détection et cette ouverture étant très rapides, l'arc est de très faible amplitude et donc sans danger.

Un dispositif selon l'invention assure donc également une fonction d'interruption du courant, sans arc électrique, lors d'une déconnection volontaire ou accidentelle en fonctionnement de la liaison entre les modules photovoltaïques 2 et le convertisseur 10.

Comme expliqué ci-dessus, cette fonction d'interruption sans arc électrique du courant lors d'une déconnection utilise de préférence un réglage particulier du dispositif.

- Dans un quatrième mode de fonctionnement, on détecte des courts-circuits.

Une protection contre les courts-circuits est réalisée par le dispositif de la figure 3B, déjà décrit ci-dessus Imes. La détection du court-circuit se fait en comparant, grâce au comparateur Comp2, le courant du capteur à un seuil égal au courant nominal fourni normalement par le module photovoltaïque, augmenté d'une fraction, par exemple 10 %, de ce courant nominal. Lorsque le seuil est dépassé, on commande l'ouverture de l'interrupteur Z1 à travers la bascule RS et la porte AND. L'interrupteur électronique Z1 interrompt alors le courant continu fourni par les modules photovoltaïques.

Une protection efficace contre les courts-circuits est donc réalisée par une détection électronique des surintensités, par mesure de courant et comparaison de cette mesure à une valeur de référence.

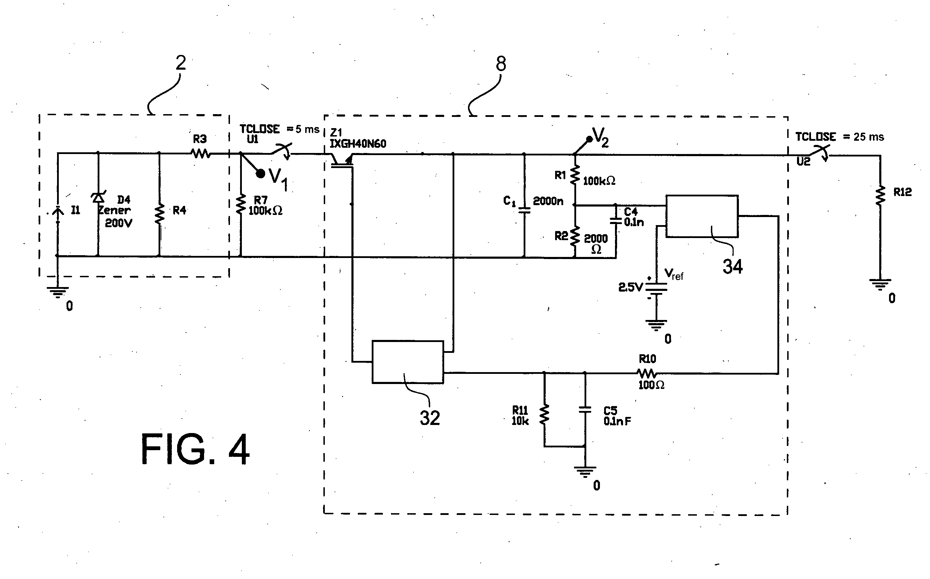

Divers modes de réalisation plus précis d'un dispositif selon l'invention vont être exposés en liaison avec les figures 4 à 11.

Ces modes de réalisation mettent en oeuvre les principes exposés précédemment. Les moyens de la figure 3B ne sont pas représentés sur ces figures mais peuvent y être incorporés. Sur les figures 4 à 11, les moyens 32, 34 réalisent respectivement les fonctions de comparateur (Compl de la figure 3) et de driver de l'interrupteur Z1 (commande isolée de la porte pour un IGBT ou un Mosfet sous une tension de 10V par rapport à sa Source ou son Emetteur). Cette fonction existe toute intégrée sous le nom de driver d'IGBT ou de Mosfet ; il est également possible de la réaliser à l'aide d'un photo-coupleur et de 2 transistors montés en push-pull.

Les autres parties sont modélisées avec des composants réels. Ne sont pas représentés les moyens de protection contre les courts-circuits, tels que les moyens Imes, Comp2, RS, AND de la figure 3B. Mais ces moyens pourraient être ajoutés sans modifier les modélisations présentées.

Des simulations de ces schémas ont été faites avec « Pspice » (c'est un logiciel du commerce destiné à la simulation des schémas électroniques. Il est commercialisé par la société Cadence) pour les valider. On présente donc chaque schéma avec sa simulation.

Un premier mode de réalisation détaillé, est illustré sur la figure 4, sur laquelle un module photovoltaïque 2, par exemple de 200 V de tension à vide et de 4A en court-circuit, est modélisée par les composants I1 (source de courant), la diode Zener D4, la résistance R4 (de valeur par exemple de 100 000 Ohms), toutes trois disposées en parallèle, une résistance R3 (de valeur par exemple 0,001 Ω) étant disposée en entrée de module. Les valeurs numériques de composants, indiquées sur cette figure ou dans le texte correspondant, le sont à titre purement indicatif et non limitatif.

Une résistance R7 permet de mesurer ce qui sort du module photovoltaïque 2.

Les composants Z1, C1, R1, R2, C2, Vref, sont ceux déjà mentionnés ci-dessus en liaison avec les figures 3A et 3B, et avec les mêmes fonctions. R10, C5 et R11 forment un filtre passe-bas permettant d'éliminer des oscillations parasites éventuelles du comparateur Comp1. Ces moyens, en combinaison avec les moyens 32, 34, permettent de modéliser un limiteur de tension selon l'invention.

La résistance R12 (de valeur par exemple 20 Ω), disposée en entrée du limiteur de tension, est une charge qui permet de simuler un convertisseur tel que le convertisseur 10 (figure 2) en fonctionnement.

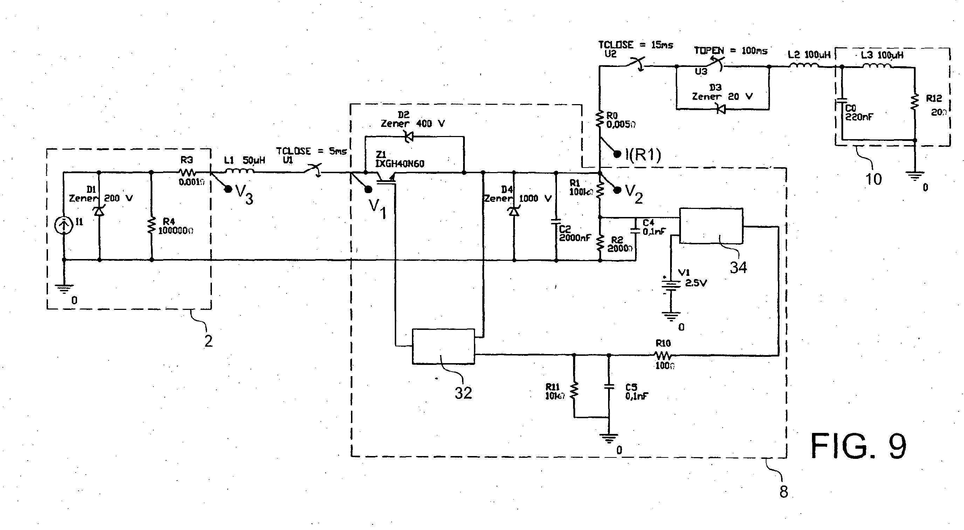

Des commutateurs U1 et U2 sont disposés respectivement entre le module photovoltaïque 2 et le limiteur 8, et entre ce dernier et le convertisseur 10. Des valeurs de durées d'ouverture (TOPEN) ou de fermeture (TCLOSE) de ces commutateurs sont indiquées sur cette figure, à titre d'exemple non limitatif. Il en va de même pour les autres valeurs indiquées pour ces interrupteurs ou pour d'autres composants, que ce soit sur la figure 4, ou sur les autres figures (par exemple : U3 sur la figure 9).

Les résultats d'une simulation de ce schéma sont illustrés en figure 5. Sur cette figure, les courbes I et II représentent respectivement :
- courbe I : la mesure de la tension V1 aux bornes de R7 (en sortie du module),
- courbe II : la mesure de la tension V2 aux bornes de R1 (en sortie de l'asservissement).

La simulation est divisée en 3 phases temporelles, activées par les 2 commutateurs U1 et U2 .

A/ De 0ms à 5 ms : le commutateur U1 est ouvert, l'asservissement et le convertisseur 10 sont hors circuit. V1 donne la mesure de la tension à vide du module photovoltaïque, soit 200V.

Sur la simulation, il apparaît que la tension aux bornes du module est à 200 V et que la tension V2 en sortie de l'asservissement (courbe II) est à 0 V.

B/ De 5 ms à 25 ms : le commutateur U1 est fermé et le commutateur U2 est ouvert.

L'asservissement est actif et le convertisseur 10 est hors circuit.

Sur la simulation, il apparaît (courbe I) que la tension V1 aux bornes du module photovoltaïque est pratiquement tout le temps à 200V (tension à vide) sauf lorsque l'asservissement prélève un peu d'énergie. Quant à la tension V2 à la sortie de l'asservissement (courbe II) elle est régulée à 130 V (tension maximum vue par le convertisseur).

C/ De 25 ms à la fin de la simulation, le commutateur U1 est fermé et le commutateur U2 est fermé. Le convertisseur 10 est actif et prélève de la puissance (4A pour une résistance de 20 ohms, soit une tension imposée de 80 V).

L'asservissement ne régule plus et l'IGBT Z1 est alors fermé en permanence pour permettre le transfert de puissance vers le convertisseur 10 avec le minimum de perte.

Sur la simulation, il apparaît que la tension V1 aux bornes du module photovoltaïque (courbe I) et la tension V2 en sortie de l'asservissement (courbe II) sont pratiquement identiques, à la chute de tension de l'IGBT près, et égale à la tension imposée par le convertisseur 10.

Le schéma de la figure 4 ne tient pas compte des inductances de câblages qui vont générer des surtensions au blocage de l'IGBT Z1.

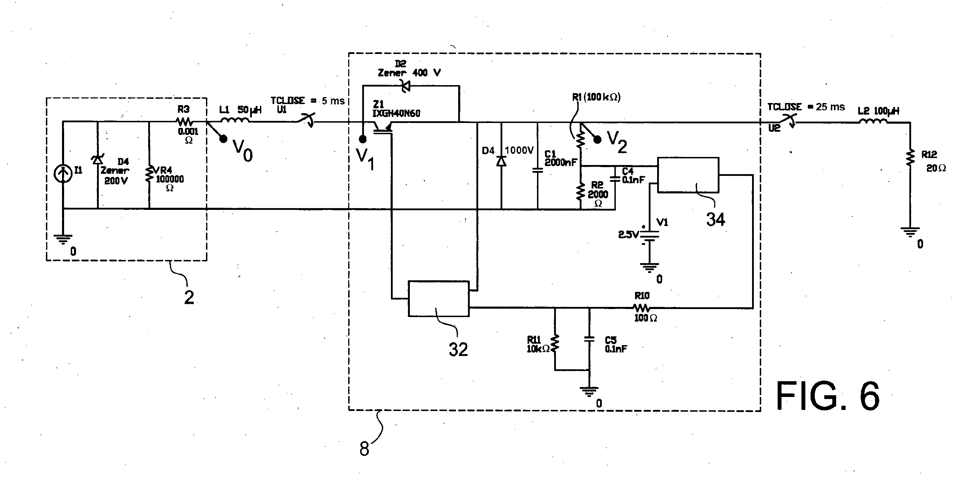

Pour tenir compte de ces inductances, un schéma modifié peut-être celui représenté en figure 6. Il s'agit de celui de la figure 4, auquel sont ajoutés:
- une inductance L1, pour tenir compte des inductances de câblage entre les modules photovoltaïques 2 et le dispositif 8 de limitation de la tension (à vide),
- une inductance L2 pour tenir compte- des inductances en aval du dispositif 8 de limitation de tension, jusqu'au convertisseur 10. L'inductance linéique du câble prise à titre d'exemple est de 1µH/m. On simule donc 25 m de câble aller/retour en amont du dispositif et 50 m aller/retour en aval.

La diode Zener D2, disposée en parallèle au composant Z1, absorbe les surtensions générées par la self L1 aux bornes de l'interrupteur U1, lors de son ouverture. Le rendement du convertisseur 10 n'a pas beaucoup d'importance, on peut donc envisager de dissiper cette énergie.

La diode D4 (de tension égale a par exemple environ 1000 V), disposée en parallèle de la capacité C1, sert de roue libre à l'inducance, L2 lorsque U2 se ferme.

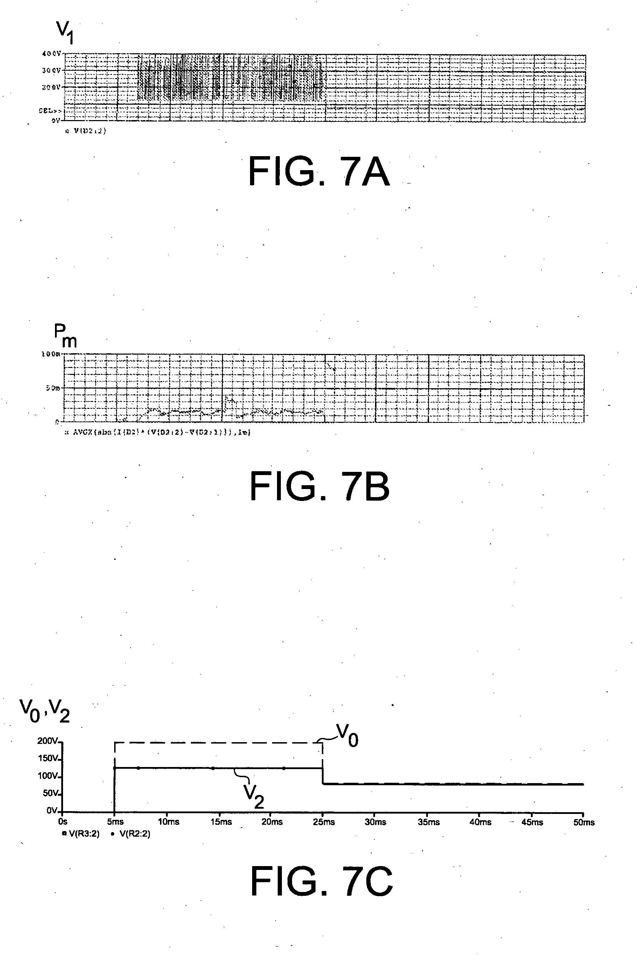

Les résultats de la simulation de ce schéma sont illustrés en figures 7A-7C.

Les phases de la simulations sont les mêmes que pour le premier schéma :
A/ de 0 à 5 ms : module photovoltaïque à vide,
B/ de 5 ms à 25 ms : module photovoltaïque et dispositif 8 de limitation tous deux en fonctionnement,
C/ de 25 ms à la fin : module photovoltaïque, dispositif 8 de limitation en fonctionnement et convertisseur 10 en charge.

La courbe de la figure 7A représente la tension V1, en amont du dispositif de limitation 8 ; elle montre les surtensions, générées par la self amont L1 et absorbées par la diode Zener D2.

La courbe de la figure 7B représente la puissance moyenne Pm dissipée par la diode D2 aux bornes de l'IGBT Z1. Cette puissance reste raisonnable et facile à dissiper dans un composant (5 mW par exemple).

La courbe de la figure 7C représente :
- la tension V2 en sortie du dispositif de limitation 8, du côté du convertisseur 10,
- la tension V0, en sortie des modules photovoltaïques 2.

Un troisième mode de réalisation détaillé est illustré sur la figure 9.

Au schéma de la figure 6, on ajoute un modèle simplifié du convertisseur 10 élévateur de tension : une capacité C0 (par exemple : 220 µF), une inductance L3 (par exemple . 100µH) et la résistance R12. L'inductance L3 de la résistance R12 sont montées en série, la capacité C0 étant disposée en parallèle, aux bornes de cet ensemble.

L'inductance L2 représente l'inductance des câbles, entre le limiteur 8 et le convertisseur 10 tandis que la résistance R0 représente la résistance de ce câble (sa prise en compte permet de réduire les oscillations des circuits LC).

Un interrupteur U3, et une diode Zener D3 montées en parallèle, sont une modélisation simplifiée d'un arc électrique et de la tension qu'il génère lorsqu'il est alimenté par un courant (tension d'environ 20 V). U3 est ouvert au bout de 100 ms pour simuler une ouverture en charge d'un connecteur avec l'apparition d'un arc électrique.

La structure d'un arc électrique a déjà été expliquée ci-dessus en liaison avec la figure 8.

Par la simulation, on modélise l'arc par une tension de 20 V (celle de la diode Zener D3) et on vérifie s'il est possible de détecter cette tension (et l'apparition d'un arc électrique) au niveau du limiteur 8 de tension, ou d'un conducteur placé entre le limiteur 8 et le convertisseur 10 et ouvert en charge par l'utilisateur.

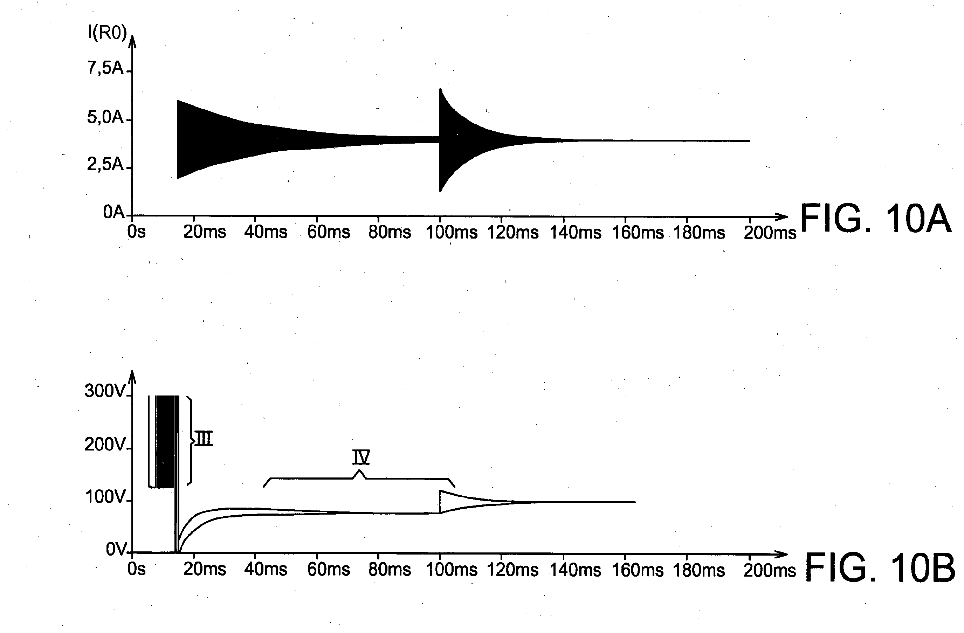

Les courbes des figures 10A et 10B montrent le résultat des simulations de ce 3^{ème} mode de réalisation. Sur ces figures :
- I(R0) représente le courant en aval du dispositif. Ce courant est fortement oscillatoire (d'où la représentation schématique en noir), ce qui est dû au circuit L2C1 de la simulation,
- les courbes de la figure 10B représentent des mesures de tension :
   a) courbe III : tension V1 (là aussi très oscillatoire) en amont du dispositif ; V1 se prolonge également au-delà de environ 15 ms, dans les limites des courbes IV,
   b) courbe IV : tension V2 en aval du dispositif, aux bornes du pont diviseur R1, R2 servant pour la mesure de tension. La simulation fait également apparaître des portions ou de oscillations avant t = 15 ms.

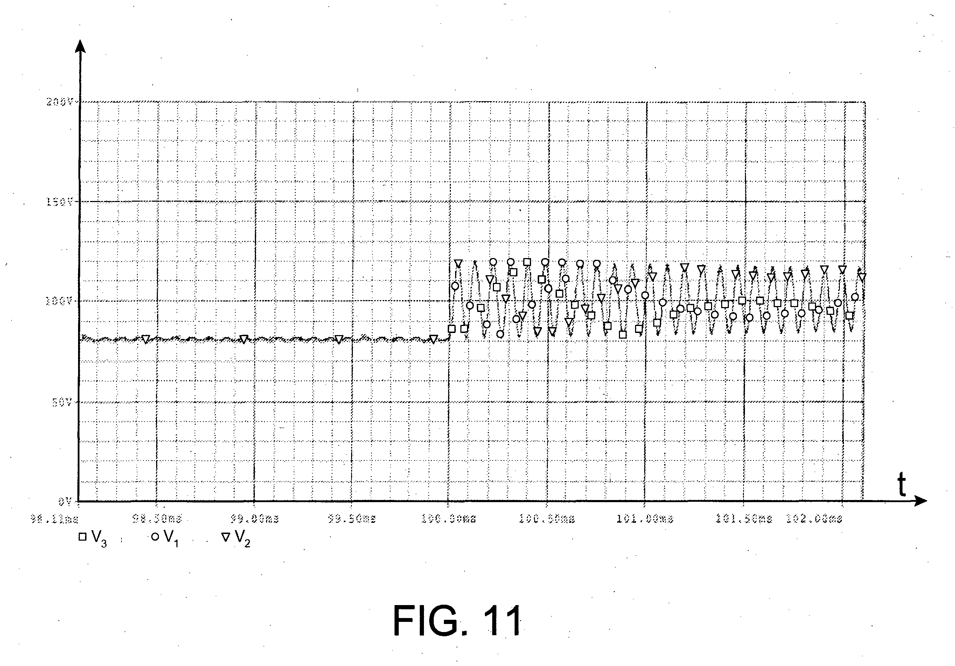

On voit nettement une variation de tension lors de l'ouverture de U3 correspondant à l'ouverture en charge du connecteur. L'agrandissement de la figure 11 montre clairement cette transition, autour de t = 100 ms.

Ces simulations montrent que l'ouverture d'un connecteur électrique en charge en aval d'un dispositif 8 selon l'invention est détectable à partir de la mesure de tension.

## Revendications

1. Dispositif (8) limiteur de tension d'un ensemble de modules photovoltaiques (2,4,6), comportant :
- des moyens (Z1) formant interrupteur électronique d'un courant dudit ensemble, pour interrompre un courant délivré par ledit ensemble de modules,
- des premiers moyens de comparaison (Comp1, R1, R2, C2) pour comparer une tension en sortie de limiteur à une valeur de tension de référence (Vref1),
- des moyens (Comp1, 11) de commande des moyens formant interrupteur électronique, pour ouvrir ou fermer ces moyens formant interrupteur, en fonction du résultat de la comparaison effectuée par les moyens de comparaison.

2. Dispositif selon la revendication 1, comportant en outre des moyens (C2) pour filtrer la tension mesurée en sortie de limiteur.

3. Dispositif selon l'une des revendications 1 ou 2, comportant en outre des moyens (C1) pour lisser une tension en sortie du dispositif limiteur.

4. Dispositif selon l'une des revendications 1 à 3, comportant en outre des moyens pour détecter une augmentation rapide de la tension en sortie du dispositif limiteur et pour comparer cette augmentation à une valeur seuil.

5. Dispositif selon la revendication 4, comportant des moyens pour calculer la dérivée temporelle de la tension en sortie du dispositif limiteur.

6. Dispositif selon l'une des revendications 1 à 5, dans lequel la tension de référence du comparateur est fixée à une valeur supérieure à la- tension correspondant au maximum de puissance du module photovoltaïque.

7. Dispositif selon la revendication 6, la tension de référence du comparateur étant fixée à une valeur supérieure à la tension correspondant au maximum de puissance du module photovoltaïque, augmentée d'une tension V' strictement positive et inférieure à la tension générée par un arc électrique.

8. Dispositif selon l'une des revendications 1 à 7, comportant en outre des moyens d'adaptation de la valeur de tension de référence (Vref1) .

9. Dispositif selon l'une des revendications 1 à 8, comportant en outre des moyens de détection de court-circuit, en aval de l'interrupteur.

10. Dispositif selon la revendication 9, les moyens de détection de court-circuit comportant un capteur de courant (Ims) disposé en aval de l'interrupteur et des deuxièmes moyens de comparaison (Comp2) pour comparer une mesure issue de ce capteur a une valeur de référence (Vref2).

11. Dispositif selon la revendication 9 ou 10, comportant en outre des moyens (RS, AND) formant moyens de commande des moyens (Z1) formant interrupteur électronique, en fonction du résultat de la comparaison effectuée par les deuxièmes moyens de comparaison (Comp2).

12. Dispositif selon l'une des revendications 1 à 11, comportant en outre des premiers et des deuxièmes moyens formant interrupteur (U1, U2) disposés respectivement en entrée et en sortie du dispositif.

13. Dispositif selon l'une des revendications 1 à 12, comportant en outre des moyens (Z2) d'absorption d'énergie entre les deux bornes des moyens formant interrupteur, afin d'écrêter des surtensions générées lors de l'ouverture de ces moyens formant interrupteur.

14. Dispositif de production d'énergie, comportant en :
- au moins un module photovoltaïque (2, 4, 6) .
- un dispositif (8) selon l'une des revendications 1 à 13,
- des moyens (10) formant convertisseur électronique, pour imposer une tension de fonctionnement au module photovoltaïque.

## Patentansprüche

1. Spannungsbegrenzervorrichtung (8) für eine Anordnung von Photovoltaikmodulen (2, 4, 6), enthaltend:
- Einrichtungen (Z1) zum Bilden eines elektronischen Schalters für einen Strom der Anordnung, um einen von der Anordnung von Modulen gelieferten Strom zu unterbrechen,
- erste Vergleichseinrichtungen (Comp1, R1, R2, C2), um eine Spannung am Ausgang des Begrenzers mit einem Referenzspannungswert (VCref1) zu vergleichen,
- Steuereinrichtungen (Comp1, 11) zum Steuern der Einrichtungen zum Bilden eines elektronischen Schalters, um diese Schaltereinrichtungen in Abhängigkeit vom Ergebnis des durch die Vergleichseinrichtungen durchgeführten Vergleichs zu öffnen bzw. zu schließen.

2. Vorrichtung nach Anspruch 1, ferner enthaltend Einrichtungen (C2) zum Filtern der am Ausgang des Begrenzers gemessenen Spannung.

3. Vorrichtung nach einem der Ansprüche 1 oder 2, ferner enthaltend Einrichtungen (C1) zum Glätten einer Spannung am Ausgang der Begrenzervorrichtung.

4. Vorrichtung nach einem der Ansprüche 1 bis 3, ferner enthaltend Einrichtungen zum Erfassen einer schnellen Erhöhung der Spannung am Ausgang der Begrenzervorrichtung und zum Vergleichen dieser Erhöhung mit einem Schwellenwert.

5. Vorrichtung nach Anspruch 4, enthaltend Einrichtungen zum Berechnen der zeitlichen Ableitung der Spannung am Ausgang der Begrenzervorrichtung.

6. Vorrichtung nach einem der Ansprüche 1 bis 5, wobei die Referenzspannung des Komparators auf einen Wert festgelegt ist, der höher als die der maximalen Leistung des Photovoltaikmoduls entsprechenden Spannung ist.

7. Vorrichtung nach Anspruch 6, wobei die Referenzspannung des Komparators auf einen Wert festgelegt ist, der höher als die der maximalen Leistung des Photovoltaikmoduls entsprechenden Spannung ist, und zwar erhöht um eine Spannung V', die streng positiv und geringer als die von einem Lichtbogen erzeugte Spannung ist.

8. Vorrichtung nach einem der Ansprüche 1 bis 7, ferner enthaltend Anpassungseinrichtungen zum Anpassen des Referenzspannungswerts (Vref1).

9. Vorrichtung nach einem der Ansprüche 1 bis 8, ferner enthaltend Erfassungseinrichtungen zum Erfassen eines Kurzschlusses stromabwärts des Schalters.

10. Vorrichtung nach Anspruch 9, wobei die Erfassungseinrichtungen zum Erfassen eines Kurzschlusses einen Stromsensor (Ims) aufweisen, der stromabwärts des Schalters angeordnet ist, sowie zweite Vergleichseinrichtungen (Comp2) zum Vergleichen einer von diesem Sensor stammenden Messung mit einem Referenzwert (Vref2).

11. Vorrichtung nach Anspruch 9 oder 10, ferner enthaltend Einrichtungen (RS, AND), die Steuereinrichtungen zum Steuern der Einrichtungen (Z1) zum Bilden des elektronischen Schalters in Abhängigkeit von dem Ergebnis des von den zweiten Vergleichseinrichtungen (Comp2) durchgeführten Vergleichs bilden.

12. Vorrichtung nach einem der Ansprüche 1 bis 11, ferner enthaltend erste und zweite Schaltereinrichtungen (U1, U2), die am Eingang bzw. am Ausgang der Vorrichtung angeordnet sind.

13. Vorrichtung nach einem der Ansprüche 1 bis 12, ferner enthaltend Einrichtungen (Z2) zum Aufnehmen von Energie zwischen den beiden Anschlüssen der Schaltereinrichtungen, um beim Öffnen dieser Schaltereinrichtungen erzeugte Überspannungen zu kappen.

14. Vorrichtung zum Erzeugen von Energie, enthaltend:
- zumindest ein Photovoltaikmodul (2, 4, 6),
- eine Vorrichtung (8) nach einem der Ansprüche 1 bis 13,
- Einrichtungen (10) zum Bilden eines elektronischen Wandlers, um dem Photovoltaikmodul eine Betriebsspannung einzuprägen.

## Claims

1. A voltage limiter device (8) of an assembly of photovoltaic modules (2,4,6), including:
- means (Z1) forming an electronic switch for a current of said assembly, in order to interrupt a current delivered by said assembly of modules,
- first comparison means (Comp1, R1, R2, C2) for comparing a voltage at the output of the limiter with a reference voltage value (Vref1),
- means (Comp1, 11) for controlling the means forming an electronic switch, in order to open or close these switch-forming means, depending on the result of the comparison carried out by the comparison means.

2. The device according to claim 1, further including means (C2) for filtering the voltage measured at the limiter output.

3. The device according to any of claims 1 or 2, further including means (C1) for smoothing voltage at the output of the limiter device.

4. The device according to any of claims 1 to 3, further including means for detecting a rapid increase in the voltage at the output of the limiter device and for comparing this increase with a threshold value.

5. The device according to claim 4, including means for calculating the time derivative of the voltage at the output of the limiter device.

6. The device according to any of claims 1 to 5, wherein the reference voltage of the comparator is set to a value above the voltage corresponding to the maximum power of the photovoltaic module.

7. The device according to claim 6, the reference voltage of the comparator being set to a value above the voltage corresponding to the maximum power of the photovoltaic module, increased by a strictly positive voltage V' less than the voltage generated by an electric arc.

8. The device according to any of claims 1 to 7, further including means for adapting the reference voltage value (Vref1).

9. The device according to any of claims 1 to 8, further including short circuit detection means, downstream from the switch.

10. The device according to claim 9, the short circuit detection means including a current sensor (Ims) positioned downstream from the switch and second comparison means (Comp2) for comparing a measurement from this sensor with a reference value (Vref2).

11. The device according to claim 9 or 10, further including means (RS, AND) forming means for controlling the means (Z1) forming an electronic switch, depending on the result of the comparison carried out by the second comparison means (Comp2).

12. The device according to any of claims 1 to 11, further including first and second switch-forming means (U1, U2) positioned at the input and at the output of the device, respectively.

13. The device according to any of claims 1 to 12, further including means (Z2) for absorbing energy between the two terminals of the switch-forming means in order to clip overvoltages generated upon opening these switch-forming means.

14. A device for producing energy, including:
- at least one photovoltaic module (2, 4, 6),
- a device (8) according to any of claims 1 to 13,
- means (10) forming an electronic converter, in order to impose an operating voltage to the photovoltaic module.
